# DEMANDE DE BREVET EUROPEEN

(11) **EP 4 760 343 A1**
(43) Date de publication de la demande: **17.06.2026**
(21) Numéro de dépôt: 25222098.3
(22) Date de dépôt: 10.12.2025
(51) Int. Cl.: G01S 7/4914, G01S 17/89, H10F 39/12

(54) **CAPTEUR D'UNE IMAGE EN PROFONDEUR À LECTURE CAPACITIVE**

(30) Priorité: 13.12.2024 FR 2414060
(71) Demandeur: Commissariat à l'Energie Atomique et aux Energies Alternatives, 75015 Paris (FR)
(72) Inventeur: PALMIGIANI, Gaëlle, 38054 GRENOBLE CEDEX 09 (FR); SAXOD, Olivier, 38054 GRENOBLE CEDEX 09 (FR)
(74) Mandataire: Santarelli

(57) **Abrégé**

L'invention porte sur un capteur comprenant un pixel de profondeur comportant une zone de stockage commandable qui comprend successivement une barrière de potentiel, une région mémoire, une zone de pincement ; une grille de transfert en vis-à-vis de la barrière ; une grille de transfert inverse en vis-à-vis de la barrière et de la région photosensible ; une grille de pincement en vis-à-vis de la mémoire formant une capacité de couplage avec la mémoire. Une voie d'écoulement de charges à l'aplomb de la région photosensible comporte une zone de collecte séparée de la région photosensible par un canal ; une grille d'initialisation en vis-à-vis du canal. Un circuit est configuré pour : échantillonner un signal dans la mémoire ; déconnecter la zone de pincement et la capacité ; vider la mémoire par activation de la grille de transfert inverse et d'initialisation ; lire un potentiel électrique de la capacité.

## Description

### DOMAINE TECHNIQUE

Le domaine de l'invention est celui des capteurs d'image en profondeur fonctionnant sur un principe de mesure indirecte de temps de vol.

### ÉTAT DE LA TECHNIQUE ANTÉRIEURE

Les capteurs d'image en profondeur permettent d'obtenir une image en relief d'une scène. Parmi ceux-ci, il existe les capteurs d'image en profondeur fonctionnant sur un principe de mesure indirecte de temps de vol, appelés généralement « capteurs d'image iToF » (iToF pour « Indirect Time of Flight », en anglais). Un tel capteur d'image en profondeur comprend généralement une matrice de pixels de profondeur. Il est associé à une source lumineuse, par exemple un laser, pour éclairer la scène. La source lumineuse émet un signal lumineux périodique en amplitude, souvent sinusoïdal. Un pixel, ou un groupe de pixels contigus correspondant à un point de l'image, échantillonne le signal périodique reçu après réflexion sur la scène. Le capteur comprend des moyens de traitement permettant de déterminer un déphasage entre les signaux périodiques émis et reçus, et de convertir le déphasage en une distance séparant le capteur d'image du point de la scène conjugué avec le point de l'image.

Il est communément admis qu'au moins trois échantillons sur une période du signal périodique sont nécessaires pour effectuer une mesure de distance. Il est préférable d'utiliser au moins quatre échantillons. Un échantillon est une intégration du signal périodique reçu par un pixel pendant une ou plusieurs périodes de temps, chacune égale à une fraction de la période du signal périodique, les périodes de temps étant espacées d'une période du signal périodique. De préférence, la fraction de la période du signal périodique est la même pour tous les échantillons, par exemple égale à l'inverse du nombre d'échantillons. Généralement, les périodes de temps d'intégration d'échantillons distincts ne se recouvrent pas.

Un pixel de profondeur comprend typiquement une région photosensible configurée pour convertir les photons du signal lumineux reçu en charges électriques, ainsi qu'un transistor de transfert et un nœud de lecture par branche d'échantillonnage ou pour plusieurs branches d'échantillonnage. Le transistor de transfert permet de transférer les charges électriques depuis la région photosensible vers le nœud de lecture pendant les périodes de temps correspondant à un échantillon.

Parmi les pixels de profondeur fonctionnant sur un principe de mesure indirecte de temps de vol, on distingue deux familles, à savoir les architectures en charges et les architectures en tension.

Dans un pixel de profondeur selon une architecture en tension, le nœud de lecture est directement connecté à une source ou un drain du transistor de transfert. Le transistor de transfert bascule à l'état passant au cours des périodes de temps d'intégration d'un échantillon. Ainsi, des charges photo-générées s'accumulent sur le nœud de lecture au cours d'une phase d'échantillonnage, faisant varier un potentiel d'échantillonnage du nœud de lecture. Le potentiel d'échantillonnage est ensuite lu en fin de phase d'échantillonnage. Le nœud de lecture doit être réinitialisé entre chaque prise d'échantillon. Il peut être réinitialisé à un potentiel d'initialisation en début de phase d'échantillonnage et/ou après la lecture du potentiel d'échantillonnage. La lecture du potentiel d'échantillonnage est comparée à une lecture du potentiel d'initialisation sur le nœud de lecture pour déterminer la valeur de l'échantillon. Cependant la réinitialisation du nœud de lecture ajoute un bruit thermique au potentiel d'initialisation, communément appelé bruit kTC, qui se répercute sur la valeur de l'échantillon dans ce type d'architecture.

Une architecture en charges permet de mettre en œuvre une technique de réduction du bruit kTC connue sous le nom de double échantillonnage corrélé (ou CDS, pour « Correlated Double Sampling » en anglais). Un pixel de profondeur selon une architecture en charges comporte une mémoire et un deuxième transistor de transfert pour chaque branche d'échantillonnage, agencés entre le transistor de transfert et le nœud de lecture. La mémoire est par conséquent dissociée du nœud de lecture par le canal du deuxième transistor de transfert. Un exemple de pixel de profondeur présentant une architecture en charges est donné dans le document US 2019/0086519.

Les charges photo-générées s'accumulent dans la mémoire au cours des périodes de temps d'intégration d'un échantillon. A la fin de la phase d'échantillonnage, le nœud de lecture est réinitialisé à un potentiel d'initialisation qui est lu avant un transfert des charges électriques stockées dans la mémoire vers le nœud de lecture par activation du deuxième transistor de transfert. Une lecture du potentiel du nœud de lecture après transfert est soustraite à la valeur lue du potentiel d'initialisation pour obtenir la valeur de l'échantillon. Les deux lectures se faisant immédiatement l'une après l'autre, sans commutation d'un interrupteur, les bruits kTC sont corrélés et sont donc éliminés lors de la soustraction.

Pour une architecture en charges, la mémoire est cependant encombrante et occupe souvent une zone aveugle du pixel de profondeur. Or, il n'est pas souhaitable d'en réduire son empreinte au risque de compromettre une dynamique de détection des échantillons, c'est-à-dire la différence maximale entre deux valeurs d'échantillons que le pixel de profondeur ou le capteur d'image peut enregistrer simultanément. Cette contrainte est d'autant plus exacerbée que la taille du pixel de profondeur est réduite pour augmenter une résolution du capteur, ou que la région photosensible est grande pour augmenter sa sensibilité.

Il existe des capteurs d'image particuliers, souvent appelés capteurs RGBZ, permettant d'obtenir une image en intensité d'une scène contenant une information de distance entre le capteur et la scène. De tels capteurs comportent généralement une pluralité de blocs de pixels, chaque bloc de pixels comprenant un groupe image d'au moins un pixel d'intensité et un macro-pixel Z d'au moins un pixel de profondeur. Le groupe image est configuré pour fournir une information d'intensité d'une scène observée. Le macro-pixel Z est configuré pour donner une information de distance séparant la scène du capteur. Dans un capteur RGBZ, le groupe image consiste généralement en trois pixels d'intensité, un pixel sensible dans le rouge, un dans le vert et un dans le bleu. L'ensemble des pixels est agencé en matrice. Il est par conséquent préférable que les pixels de profondeur aient sensiblement la même taille que les pixels d'intensité. Il est donc souhaitable que la taille des pixels de profondeur suive la même tendance de réduction que les pixels d'intensité. Ceci rend souvent difficile, voire impossible l'adoption d'une architecture en charges.

Il existe donc un besoin pour un pixel de profondeur plus compact et/ou une nouvelle architecture de pixel de profondeur permettant un double échantillonnage corrélé, sans compromission sur la taille du pixel de profondeur, la résolution ou la sensibilité du capteur d'image.

### EXPOSÉ DE L'INVENTION

L'invention a pour objectif de remédier au moins en partie aux inconvénients de l'art antérieur, et plus particulièrement de proposer un capteur d'image comportant une pluralité de pixels dont au moins un est un pixel de profondeur plus compact que les pixels de profondeur de l'art antérieur.

Pour cela, l'objet de l'invention est un capteur d'une image comprenant un circuit de lecture et une pluralité de pixels formés dans et/ou sur un substrat semiconducteur du capteur, tel qu'au moins un parmi les pixels est un pixel de profondeur, chaque pixel de profondeur comportant une région photosensible du substrat et une zone de stockage commandable. La zone de stockage commandable comprend une voie d'écoulement de charges électriques s'étendant verticalement dans le substrat à l'aplomb de la région photosensible et comportant, dans des plans successifs depuis la région photosensible, une barrière de potentiel nommée barrière, un puits de potentiel nommé région mémoire, et une zone de pincement ; une grille de transfert s'étendant verticalement dans le substrat à l'aplomb de la région photosensible, en vis-à-vis de la barrière ; une grille de transfert inverse s'étendant verticalement dans le substrat en vis-à-vis de la barrière et d'une partie supérieure de la région photosensible ; une grille de pincement s'étendant verticalement dans le substrat en vis-à-vis de la région mémoire ; une capacité de couplage comprenant une première borne formée par la région mémoire et une deuxième borne formée par une partie conductrice de la grille de transfert ou de la grille de pincement.

Chaque pixel de profondeur comporte une voie additionnelle d'écoulement de charges électriques s'étendant verticalement dans le substrat à l'aplomb de la région photosensible comportant un puits de potentiel nommé zone de collecte et une barrière de potentiel, nommée canal de collecte, intercalée entre la zone de collecte et la région photosensible ; une grille d'initialisation s'étendant verticalement dans le substrat à l'aplomb de la région photosensible, en vis-à-vis du canal de collecte.

Le circuit de lecture est configuré pour successivement : appliquer un train d'impulsions périodique à la grille de transfert au cours d'une phase d'échantillonnage de sorte à écouler des charges électriques depuis la région photosensible vers la région mémoire au cours des impulsions ; appliquer une différence de potentiel électrique entre la zone de pincement et la grille de pincement, et une différence de potentiel électrique entre la zone de pincement et la grille de transfert, de sorte à passiver la région mémoire à partir de charges électriques issues de la zone de pincement ; déconnecter, puis maintenir déconnectées, la zone de pincement et la deuxième borne ; activer la grille de transfert inverse et la grille d'initialisation de sorte à écouler des charges électriques depuis la région mémoire vers la zone de collecte au cours d'une phase d'évacuation de charges ; lire un potentiel électrique Vsig de la deuxième borne, tout en maintenant déconnectées la zone de pincement et la deuxième borne.

Certains aspects préférés mais non limitatifs de ce capteur sont les suivants.

Le circuit de lecture peut être configuré pour lire un potentiel électrique Vinit de la deuxième borne antérieurement à la phase d'évacuation de charges et postérieurement à la déconnexion de la zone de pincement et de la deuxième borne. Le capteur peut comprend des moyens pour opérer un double échantillonnage corrélé à partir de Vinit et Vsig.

La deuxième borne de la capacité de couplage peut être formée par une partie conductrice de la grille de pincement. Le circuit de lecture peut comporter en outre un module de contrôle connecté électriquement à la deuxième borne, à la grille de transfert inverse et à la grille d'initialisation. Le module de contrôle peut être configuré pour successivement : incrémenter un compteur du module de contrôle ; activer la grille de transfert inverse et la grille d'initialisation de sorte à écouler les charges électriques depuis la région mémoire vers la zone de collecte, à chaque fois qu'un potentiel électrique Vd de la deuxième borne franchit un seuil de potentiel prédéterminé au cours de la phase d'échantillonnage ; le capteur pouvant être tel que les moyens pour opérer le double échantillonnage corrélé prennent en compte un incrément du compteur à l'issue de la phase d'échantillonnage.

Le circuit de lecture peut être en outre configuré pour activer la grille de transfert au cours de la phase d'évacuation de charges après l'activation de la grille de transfert inverse.

Le circuit de lecture peut être configuré pour activer la grille d'initialisation en opposition de phase de la grille de transfert au cours de la phase d'échantillonnage.

Pour chaque pixel de profondeur, la grille de transfert peut s'étendre en regard de la région mémoire.

Pour chaque pixel de profondeur, la barrière, la région mémoire et la zone de collecte peuvent être dopées d'un premier type de conductivité, et peuvent avoir des concentrations en éléments dopants respectivement égales à N1, N2, N3 telles que N1 est strictement inférieur à N2, et N2 est strictement inférieur à N3.

Pour chaque pixel de profondeur, la zone de pincement peut être dopée d'un deuxième type de conductivité opposé au premier type de conductivité.

Le canal de collecte peut avoir une concentration en éléments dopants égale à N1.

Pour chaque pixel de profondeur, la grille de transfert peut avoir une forme en U en vue de dessus, pouvant entourer la voie d'écoulement de la zone de stockage commandable.

La pluralité de pixels est agencée en matrice. Chaque pixel peut comporter une tranchée d'isolation périphérique pouvant s'étendre verticalement dans une région périphérique du pixel en regard d'une région photosensible du pixel. Le circuit de lecture peut être configuré pour appliquer un potentiel électrique fixe commun à toutes les tranchées d'isolation périphérique.

Chaque grille de pincement et chaque grille de transfert inverse peuvent être agencées dans des plans de séparation de deux pixels contigus de la matrice de pixels.

Les tranchées d'isolation périphérique peuvent former un maillage continu comportant des mailles telles que chaque maille entoure deux pixels. Le circuit de lecture peut être connecté électriquement à une zone périphérique du maillage de sorte à appliquer le potentiel électrique fixe commun.

Tous les pixels de la matrice peuvent avoir la même taille. La matrice de pixels peut comporter des pixels d'intensité configurés pour délivrer un signal représentatif d'une intensité d'un flux lumineux incident.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique de dessus d'un exemple de pixel de profondeur selon l'invention ;
la figure 1B est une vue schématique selon la coupe A-A de la figure 1A de l'exemple de pixel de profondeur ;
la figure 2A est un schéma électrique d'un premier circuit de lecture adapté au pixel de profondeur des figures 1A et 1B ;
la figure 2B est un chronogramme illustrant un fonctionnement possible du premier circuit de lecture ;
la figure 3A est un schéma électrique d'un deuxième circuit de lecture adapté au pixel de profondeur des figures 1A et 1B ;
la figure 3B est un chronogramme illustrant un fonctionnement possible du deuxième circuit de lecture ;
les figures 4A à 4D illustrent des variations de potentiels électriques au sein du pixel de profondeur des figures 1A et 1B ;
la figure 5 est un schéma électrique d'une variante du deuxième circuit de lecture ;
la figure 6 est une vue schématique partielle, de dessus, d'une matrice de pixels de profondeur ;
la figure 7 est une vue schématique partielle, de dessus, d'une matrice de pixels mixant des pixels d'intensité et des pixels de profondeur ;
la figure 8 est une vue schématique selon la coupe A-A de la figure 6 ou de la figure 7.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un capteur d'une image. Le capteur comprend un substrat, un circuit de lecture et une pluralité de pixels formés dans et/ou sur le substrat. Au moins un pixel parmi la pluralité de pixels est un pixel de profondeur.

Chaque pixel de profondeur comporte une région photosensible et une zone de stockage commandable agencée à l'aplomb de la région photosensible. La zone de stockage commandable comporte une voie d'écoulement de charges électriques, une grille de transfert, une grille de transfert inverse et une grille de pincement. La voie d'écoulement comprend une région mémoire séparée de la région photosensible par une barrière.

Les grilles s'étendent verticalement dans le substrat. La grille de transfert est à l'aplomb de la région photosensible. Un nœud de lecture du circuit de lecture est connecté électriquement à la grille de transfert ou à la grille de pincement. La grille de transfert et la grille de transfert inverse s'étendent en vis-à-vis de la barrière, de sorte que cette dernière est commandable indifféremment par la grille de transfert ou par la grille de transfert inverse, ou par les deux simultanément. La grille de transfert inverse s'étend en outre en vis-à-vis de la région photosensible, de façon à pouvoir faire changer de signe une différence de potentiels électriques entre la région mémoire et la région photosensible.

Cet agencement en combinaison avec une configuration particulière du circuit de lecture permet de commander la zone de stockage de façon à permettre un écoulement à double sens des charges électriques dans la voie d'écoulement. Il est ainsi possible d'accumuler des charges électriques photo-générées dans la région mémoire au cours d'une phase d'échantillonnage et de les évacuer au cours d'une phase de lecture. L'évacuation des charges électriques rend possible une variation d'un potentiel électrique de la région mémoire équivalente au nombre de charges accumulées, qui est lue sur une borne d'une capacité de couplage comprenant la grille connectée au nœud de lecture. La région mémoire ainsi vidée peut servir de réceptacle pour une nouvelle phase d'échantillonnage.

En fonctionnement, la région photosensible est destinée à recevoir un rayonnement électromagnétique incident sur une face inférieure du substrat opposée à la zone de stockage commandable. Ainsi, le pixel de profondeur est compact et ne présente pas ou peu de zones aveugles.

Des modes de réalisation particuliers vont être décrits se rapportant à un capteur d'une image comportant un circuit de lecture à base de transistors PMOS. Cependant, ces modes de réalisation peuvent être adaptés à d'autres types de circuit de lecture permettant de mettre en œuvre l'enseignement technique de la description sans sortir du cadre de l'invention, par exemple un circuit de lecture à base de transistors NMOS ou une combinaison de transistors NMOS et PMOS.

Similairement, chaque mode de réalisation décrit ci-après adopte une combinaison particulière de conductivités associées aux zones dopées, étant entendu que la combinaison peut être inversée sans sortir du cadre de l'invention. Ainsi, pour un mode de réalisation particulier toutes les zones dopées P peuvent être dopées N et toutes les zones dopées N peuvent être dopées P, à condition de changer le type de conductivité de toutes les zones dopées. Les exemples de potentiels électriques ou tensions de polarisation données dans la description sont données relativement à la combinaison particulière de conductivités et de concentrations de dopage prise pour les exemples de réalisation, en association avec un exemple de circuit de lecture PMOS. Il est à la portée de la personne du métier d'établir les potentiels électriques et/ou les tensions de polarisation convenant à d'autres combinaisons possibles dans le cadre de l'invention.

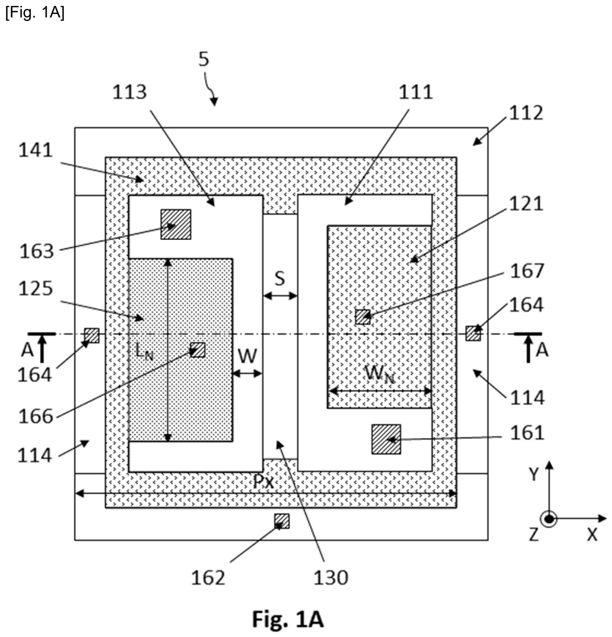

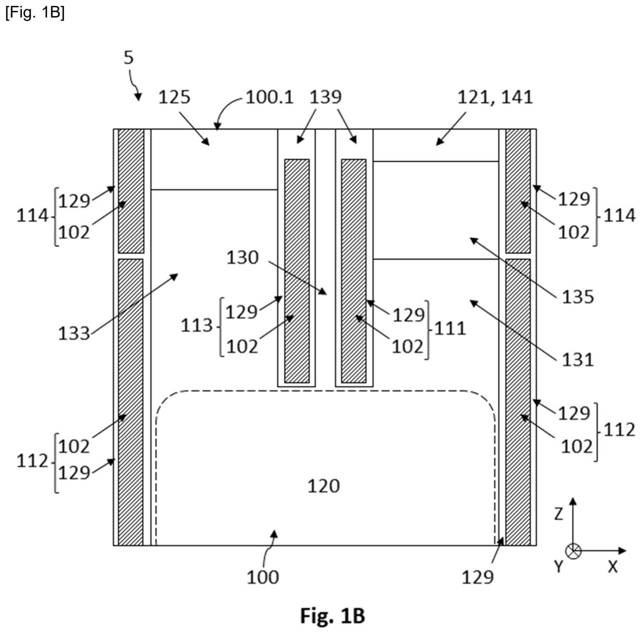

Un exemple de pixel de profondeur 5 d'un capteur d'une image selon l'invention va à présent être décrit en lien avec les figures 1A et 1B. Les figures 1A et 1B sont des vues schématiques respectivement, de dessus et en coupe. Le plan de coupe de la figure 1B est représenté par une ligne mixte sur la figure 1A.

Le capteur d'une image comprend un circuit de lecture et une pluralité de pixels formés dans et sur un substrat 100, dont au moins un est un pixel de profondeur 5. Sur les figures 1A à 1B, seul un pixel de profondeur 5 a été représenté. Pour ne pas surcharger les schémas, certains éléments ont été omis, comme par exemple des lignes d'interconnexion ou certains contacts électriques. Pour en améliorer la lisibilité, seule une partie supérieure du substrat 100 est représentée sur la vue en coupe. Sur les vues schématiques, les éléments sont représentés par des formes géométriques simples. Ceux-ci sont reproduits sur le dispositif réalisé à des erreurs de fabrication près, comme par exemple des erreurs d'alignement, de dimensionnel ou des arrondis de coins induits par un manque de résolution.

Le substrat 100 comporte une face supérieure 100.1 et une face inférieure opposée à la face supérieure 100.1. Les faces inférieure et supérieure 100.1 sont sensiblement planes et parallèles entre elles. Le pixel de profondeur 5 comprend une région photosensible 120, une zone de stockage commandable. La zone de stockage commandable comporte une voie d'écoulement. La voie d'écoulement comprend une barrière 131, une région mémoire 135 et une zone de pincement 121.

Le pixel de profondeur 5 comporte en outre une voie d'écoulement additionnelle et une grille d'initialisation 113. La voie d'écoulement additionnelle comprend une zone de collecte 125 et un canal de collecte 133. Dans cet exemple, la zone de pincement 121 et la zone de collecte 125 affleurent la face supérieure 100.1. La voie d'écoulement de la zone de stockage commandable et la voie d'écoulement additionnelle s'étendent verticalement dans le substrat 100 à l'aplomb de la région photosensible 120, entre la région photosensible 120 et la face supérieure 100.1 du substrat 100.

On définit ici et pour la suite de la description un repère direct tridimensionnel orthogonal (X, Y, Z), où les axes X et Y forment un plan parallèle à la face supérieure 100.1 du substrat 100, l'axe X étant orienté dans le plan de coupe A-A, et où l'axe Z est orienté de manière sensiblement orthogonale à la face supérieure 100.1, depuis la région photosensible 120 vers la face supérieure 100.1. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne de la face supérieure 100.1 du substrat 100, suivant la direction +Z. Le terme « latéral » se réfère à une orientation sensiblement parallèle à l'axe Z.

Le substrat 100 est en un matériau semiconducteur. Il est ici en silicium cristallin. Il s'agit par exemple d'une plaque en silicium ou d'une partie d'une plaque en silicium. Il peut comprendre une ou plusieurs couches épitaxiées en silicium cristallin, ainsi qu'une ou plusieurs couches de passivation.

La barrière 131 est agencée entre la région photosensible 120 et la région mémoire 135. La barrière 131 constitue une barrière de potentiel électrique pour des charges électriques destinées à être photo-générées dans la région photosensible 120. Les charges électriques photo-générées sont ici des électrons d'une bande de conduction de la région photosensible 120. La région mémoire 135 constitue un puits de potentiel électrique pour les charges électriques photo-générées.

La zone de pincement 121 recouvre la région mémoire 135, d'un côté de la région mémoire 135 opposé à la barrière 131. La zone de pincement 121 recouvre de préférence entièrement la région mémoire 135. La zone de stockage commandable comporte en outre une grille de pincement 114. La grille de pincement 114 s'étend verticalement dans le substrat 100 en vis-à-vis de la région mémoire 135. La zone de pincement 121 et/ou la grille de pincement 114 sont destinées à fixer un potentiel électrique, dit de pincement, de la région mémoire 135. De préférence, La zone de pincement 121 et/ou la grille de pincement 114 sont destinées à dépléter la région mémoire 135 en absence de charges électriques photo-générées.

La zone de stockage commandable comporte en outre une grille de transfert 111, une grille de transfert inverse 112. La grille de transfert 111 s'étend verticalement dans le substrat 100 à l'aplomb de la région photosensible 120 entre la face supérieure 100.1 et la région photosensible 120. Elle s'étend en vis-à-vis de la barrière 131. De préférence, comme cela est le cas ici, elle s'étend verticalement en vis-à-vis de la région mémoire 135.

La grille de transfert inverse 112 s'étend verticalement dans le substrat 100 en vis-à-vis de la barrière 131 et d'une partie supérieure de la région photosensible 120, de préférence en vis-à-vis de toute la région photosensible 120. Avantageusement, la grille de transfert inverse 112 s'étend sensiblement jusqu'à la face inférieure du substrat 100. Elle délimite ici la région photosensible 120 dans un plan horizontal. En vue de dessus, elle entoure de toutes parts la région photosensible 120 et présente un contour fermé, ici de forme sensiblement carrée, de côtés parallèles à l'axe X ou à l'axe Y. Dans un plan parallèle à la face supérieure 100.1, la distance Px séparant un bord externe d'un côté du carré à un bord interne du côté opposé du carré définit une taille du pixel. Dans cet exemple, la taille Px du pixel est égale à 1,2 µm. Elle peut être inférieure ou égale à 1,2 µm, voire inférieure ou égale à 1 µm.

Une ou des distances horizontales séparant la grille de transfert 111 de la grille de transfert inverse 112 au niveau de la barrière 131 et une concentration en éléments dopants de la barrière 131 sont de nature à réaliser une barrière de potentiel électrique au niveau de la barrière 131, entre la région photosensible 120 et la région mémoire 135. Similairement, une ou des distances horizontales séparant la grille de transfert 111 de la grille de pincement 114 et une concentration en éléments dopants de la région mémoire 135 sont de nature à réaliser un puits de potentiel électrique au niveau de la région mémoire 135, entre la barrière 131 et la zone de pincement 121. La grille de transfert 111 et la grille de transfert inverse 112 sont en regard l'une de l'autre au niveau de la barrière 131 de sorte que celle-ci est commandable indifféremment par l'une ou l'autre de la grille de transfert 111 ou de la grille de transfert inverse 112, ou simultanément par les deux.

Dans cet exemple, la région photosensible 120, la barrière 131 et la région mémoire 135 sont dopées d'un premier type de conductivité. Ici, le premier type de conductivité est de type n. La barrière 131 et la région mémoire 135 ont des concentrations en éléments dopants respectivement égales à N1 et N2, telles que N1 est strictement inférieure à N2.

La barrière 131 s'étend horizontalement de la grille de transfert 111 jusqu'à la grille de transfert inverse 112. La région mémoire 135 s'étend horizontalement de la grille de transfert 111 jusqu'à la grille de pincement 114. Ici, la grille de pincement 114 occupe une encoche pratiquée dans la grille de transfert inverse 112. Elle est sensiblement plane.

Le canal de collecte 133 est agencé entre la région photosensible 120 et la zone de collecte 125. Le canal de collecte 133 constitue une barrière de potentiel électrique pour les charges électriques destinées à être photo-générées dans la région photosensible 120. La zone de collecte 125 constitue un puits de potentiel électrique pour les charges électriques photo-générées.

La grille d'initialisation 113 s'étend verticalement dans le substrat 100 à l'aplomb de la région photosensible 120, en vis-à-vis du canal de collecte 133. Ici, la grille de transfert inverse 112 s'étend verticalement en vis-à-vis du canal de collecte 133. Optionnellement, comme ici, le pixel de profondeur 5 peut comprendre une grille de pincement 114 additionnelle s'étendant verticalement en vis-à-vis de la zone de collecte 125. Dans cet exemple, la grille de pincement 114 additionnelle a toutes ses dimensions identiques à la grille de pincement 114 de la zone de stockage commandable. Les deux grilles de pincement 114 sont symétriques l'une de l'autre par rapport à un plan de symétrie parallèle au plan (Y, Z) passant par le centre du pixel de profondeur 5. La grille de transfert inverse 112 est symétrique par rapport à ce plan. La grille de pincement 114 additionnelle peut s'étendre en vis-à-vis du canal de collecte 133, en partie ou en totalité.

Une ou des distances horizontales séparant la grille d'initialisation 113 de la grille de transfert inverse 112 au niveau du canal de collecte 133 et une concentration en éléments dopants du canal de collecte 133 sont de nature à réaliser une barrière de potentiel électrique au niveau du canal de collecte 133, entre la région photosensible 120 et la zone de collecte 125. Similairement, une ou des distances horizontales séparant la grille d'initialisation 113 de la grille de pincement 114 additionnelle et une concentration en éléments dopants du canal de collecte 133 sont de nature à réaliser un puits de potentiel électrique au niveau de la zone de collecte 125 et une barrière de potentiel électrique entre la région photosensible 120 et la zone de collecte 125.

Dans cet exemple, le canal de collecte 133 et la zone de collecte 125 sont dopés du premier type de conductivité. La zone de collecte 125 a une concentration en éléments dopants égale à N3, telle que N2 est strictement inférieure à N3. Le canal de collecte 133 peut avoir une concentration en éléments dopants égales à la barrière 131, comme cela est le cas dans cet exemple. Le cas échéant, les dopages du canal de collecte 133 et de la barrière 131 peuvent résulter d'un dopage in-situ lors d'une croissance par épitaxie. La croissance par épitaxie peut inclure la formation de la région photosensible 120.

Le canal de collecte 133 s'étend horizontalement depuis la grille d'initialisation 113 jusqu'à la grille de transfert inverse 112. La zone de collecte 125 s'étend horizontalement depuis la grille d'initialisation 113 jusqu'à la grille de pincement 114 additionnelle.

Toutes les grilles du pixel de profondeur 5 parmi un ensemble de grilles consistant en la grille de transfert 111, la grille de transfert inverse 112, la grille de pincement 114, la grille de pincement 114 additionnelle, et la grille d'initialisation 113, peuvent chacune affleurer la face supérieure 100.1 du substrat 100, sans que cela soit indispensable. Chaque grille de l'ensemble de grilles comporte une électrode 102 en un matériau conducteur de l'électricité, comme un métal ou un semiconducteur dopé. Les électrodes 102 sont avantageusement en un même matériau. Elles sont ici toutes en silicium polycristallin dopé. Elles sont dopées d'un deuxième type de conductivité opposé au premier type de conductivité, c'est-à-dire dopées p dans cet exemple.

La région photosensible 120 peut être dopée ou intrinsèque. Une géométrie de la grille de transfert inverse 112 et une concentration en éléments dopants de la région photosensible 120 sont telles que la région mémoire 135 a un potentiel électrique intermédiaire entre un potentiel électrique de la région photosensible 120 et un potentiel électrique de la zone de collecte 125, lorsque toutes les grilles de l'ensemble de grilles sont au même potentiel électrique. Le potentiel électrique de la région photosensible 120 peut être égal au potentiel électrique de la région mémoire 135.

L'électrode 102 de chaque grille de l'ensemble de grilles est revêtue d'un revêtement diélectrique 129 de la grille. Les revêtements diélectriques 129 sont en tout matériau diélectrique. Ils sont ici en oxyde de silicium. Chaque grille est isolée électriquement du substrat 100 semiconducteur par un revêtement diélectrique 129. Un revêtement diélectrique 129 isole électriquement l'électrode 102 de la grille de pincement 114 de l'électrode 102 de la grille de transfert inverse 112, ainsi que l'électrode 102 de la grille de pincement 114 additionnelle de l'électrode 102 de la grille de transfert inverse 112.

Les grilles de transfert 111 et d'initialisation 113 comportent chacune une région isolante 139 recouvrant leurs électrodes 102 respectives et affleurant la face supérieure 100.1 du substrat 100. Les région isolante 139 sont en tout matériau diélectrique. Elles sont ici en oxyde de silicium.

La zone de pincement 121 est dopée du deuxième type de conductivité, dopée p dans cet exemple. Elle comporte avantageusement une zone dopée périphérique 141 s'étendant horizontalement dans une région périphérique du pixel de profondeur 5. La zone de pincement 121 a une concentration P1 en éléments dopants. Elle peut s'étendre plus profondément dans le substrat 100 au niveau de sa zone dopée périphérique 141. Dans cet exemple, elle s'étend verticalement dans le substrat 100 sur une profondeur sensiblement constante, par exemple supérieure ou égale à une hauteur selon l'axe Z des régions isolantes 139. La zone de pincement 121 avec sa zone dopée périphérique 141 peut par exemple être obtenue par une étape d'implantation localisée unique. Ici, la zone dopée périphérique 141 entoure la grille de transfert 111 et la grille d'initialisation 113. Elle a un pourtour externe en contact sur toute sa surface avec une grille parmi la grille de pincement 114, la grille de pincement 114 additionnelle et la grille de transfert inverse 112.

La grille d'initialisation 113 est agencée dans le pixel de profondeur 5 de sorte à écranter dans le canal de collecte 133, un champ électrique émis par la grille de transfert 111, lorsque le capteur est en fonctionnement. Similairement, la grille de transfert 111 est agencée de sorte à écranter dans la barrière 131, un champ électrique émis par la grille d'initialisation 113, lorsque le capteur est en fonctionnement. On y parvient ici en intercalant la grille de transfert 111 et la grille d'initialisation 113 entre les deux voies d'écoulement. Les grilles de transfert 111 et d'initialisation 113 sont séparées d'une distance S mesurée parallèlement à l'axe X. A titre d'exemple, la distance S est comprise entre 10 nm et 300 nm, ici égale à 70 nm. L'espace séparant la grille de transfert 111 de la grille d'initialisation 113 est en tout matériau diélectrique ou semiconducteur. Il est ici en silicium cristallin.

La grille de transfert 111 présente une forme en U en vue de dessus, entourant la voie d'écoulement. Elle comporte une portion principale formant la base du U, s'étendant parallèlement au plan (Y, Z), ainsi qu'une première branche et une deuxième branche du U s'étendant parallèlement au plan (X, Z). Dans cet exemple, la portion principale et la première branche ont des largeurs horizontales sensiblement égales à une valeur W. La deuxième branche a ici une largeur horizontale strictement supérieure à W. La largeur horizontale de la deuxième branche est par exemple suffisante pour garantir qu'un premier contact 161 du circuit de lecture repose entièrement sur la deuxième branche malgré des incertitudes de fabrication. W est ici égal à 110 nm. La largeur de la deuxième branche est ici égale à 200 nm. Les première et deuxième branches ont des longueurs égales W_{N}, mesurées parallèlement à l'axe X. W_{N} est ici égale à 336 nm. La première branche est séparée de la deuxième branche d'une distance L_{N} mesurée parallèlement à l'axe Y, égale ici à 640 nm.

La grille d'initialisation 113 est dans cet exemple, symétrique de la grille de transfert 111 par une symétrie axiale par rapport à un axe de symétrie vertical passant par le centre du pixel de profondeur 5. La grille de transfert 111 et/ou la grille d'initialisation 113 peuvent cependant avoir d'autres formes en vue de dessus, indépendamment l'une de l'autre, par exemple une forme en L ou en I, avec ou sans empattements.

Dans cet exemple, la grille de transfert inverse 112 a une largeur horizontale sensiblement constante sur tout son pourtour, ici égale à 100 nm. La grille de pincement 114 et la grille de pincement 114 additionnelle sont alignées sur des faces respectives de la grille de transfert inverse 112. Elles ont ici une largeur horizontale égale à celle de la grille de transfert inverse 112.

De préférence, la zone de collecte 125 s'étend en profondeur dans le substrat 100 depuis la face supérieure 100.1, plus profondément que les régions isolantes 139. Elle s'étend moins profondément que la grille de pincement 114 additionnelle. La région mémoire 135 s'étend en profondeur depuis la zone de pincement 121 jusqu'à la barrière 131. La grille de pincement 114 s'étend en profondeur dans le substrat 100 depuis la face supérieure 100.1. De préférence, elle s'étend jusqu'à sensiblement atteindre un plan de séparation entre la région mémoire 135 et la barrière 131, à des incertitudes de fabrication près.

Les électrodes 102 respectives de la grille de pincement 114 et de la grille de transfert inverse 112 sont isolées l'une de l'autre par le revêtement diélectrique 129. Elles sont par exemple séparées par le revêtement diélectrique 129 d'une distance comprise entre 2 nm et 100 nm, ici égale à 20 nm . Similairement, les électrodes 102 respectives de la grille de pincement 114 additionnelle et de la grille de transfert inverse 112 dont séparées par le revêtement diélectrique 129 d'une distance équivalente. Ici, les revêtements diélectriques 129 de toutes les électrode 102 de l'ensemble de grilles ont des épaisseurs sensiblement égales.

N1 est par exemple compris entre 1E10 at/cm³ et 1E18 at/cm³. N2 est par exemple compris entre 1E16 at/cm³ et 1E19 at/cm³. N3 est par exemple compris entre 1E17 at/cm³ et 5E20 at/cm³. P1 est par exemple compris entre 1E17 at/cm³ et 5E20 at/cm³.

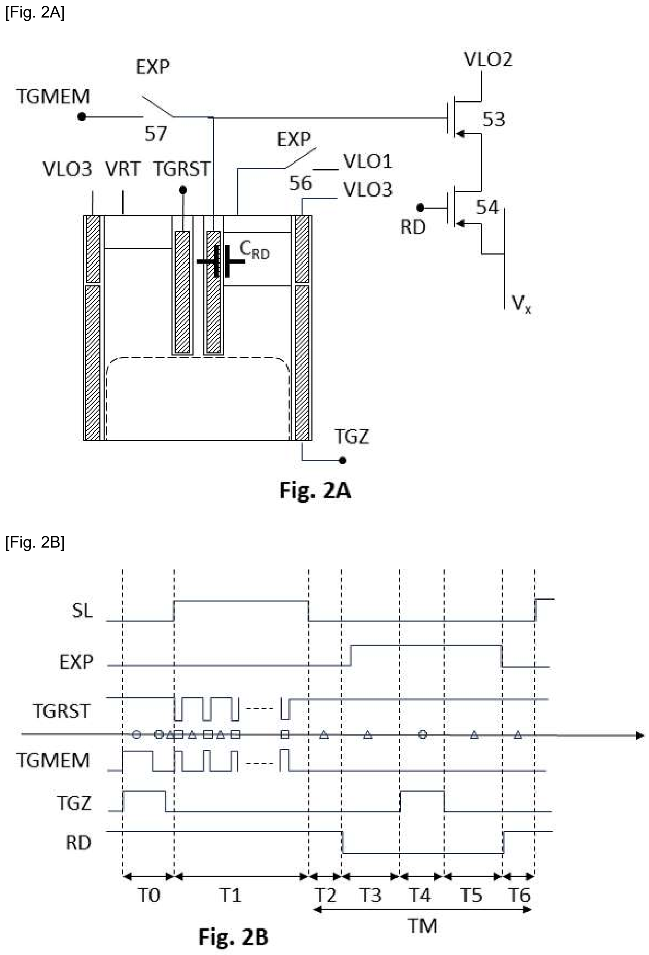

A présent, en lien avec la figure 2A, il va être décrit un premier circuit de lecture du capteur, adapté à l'exemple de pixel de profondeur 5 des figures 1A et 1B. Sur la figure 2A, on a repris la vue en coupe de la figure 1B sans les références. Des connexions électriques liant électriquement les différents éléments du pixel de profondeur 5 au premier circuit de lecture sont schématiquement représentées, mais ne sont pas nécessairement représentatives d'une disposition géométrique dans l'espace.

Le premier circuit de lecture comporte le premier contact 161, un deuxième contact 162, un troisième contact 163, un quatrième contact 164, un sixième contact 166, et un septième contact 167.

Les grilles de pincement 114 sont chacune connectée électriquement via leur quatrième contact 164, à un nœud ou un rail de fourniture d'un potentiel électrique VLO3. La zone de collecte 125 est connectée électriquement via le sixième contact 166 à un nœud ou un rail de fourniture d'un potentiel électrique VRT. La grille d'initialisation 113 est connectée électriquement via le troisième contact 163, à un nœud ou un rail de fourniture d'un potentiel électrique TGRST. La grille de transfert inverse 112 est connectée électriquement via le deuxième contact 162, à un nœud ou un rail de fourniture d'un potentiel électrique TGZ. La zone de pincement 121 est connectée électriquement à un nœud ou un rail de fourniture d'un potentiel électrique VLO1, via le septième contact 167 et un premier interrupteur 56 du premier circuit de lecture. Le premier interrupteur 56 est commandé par un potentiel électrique EXP.

Le premier circuit de lecture comporte en outre un transistor 53 monté en source suiveuse et un transistor de sélection 54. Les transistors 53 et 54 sont ici des transistors PMOS. Le drain du transistor 53 est connecté électriquement à un nœud ou un rail de fourniture d'un potentiel électrique VLO2. La source du transistor 53 est connectée électriquement au drain du transistor de sélection 54. La source du transistor de sélection 54 est connectée électriquement à une ligne de sortie présentant un potentiel électrique Vₓ. La ligne de sortie est connectée à un pied de colonne de la matrice de pixels. La grille du transistor de sélection 54 est connectée électriquement à un nœud ou un rail de fourniture d'un potentiel électrique RD. La grille de transfert 111 est connectée électriquement à un nœud de lecture via le premier contact 161. Le nœud de lecture est connecté électriquement à la grille du transistor 53. Il est en outre connecté électriquement à un nœud ou un rail de fourniture d'un potentiel électrique TGMEM via un deuxième interrupteur 57 du premier circuit de lecture. Le deuxième interrupteur 57 est commandé par le potentiel électrique EXP.

En lien avec la figure 2B, un fonctionnement possible de ce premier circuit de lecture va être illustré. La figure 2B représente un chronogramme sur lequel on a reporté des potentiels électriques variant dans le temps. Certains parmi ceux-ci sont repérés par des disques pleins sur le schéma électrique de la figure 2A. On a représenté des états de polarisation différents du pixel de profondeur 5 au cours d'un cycle du chronogramme, par des formes géométriques élémentaires placées sur une ligne de temps.

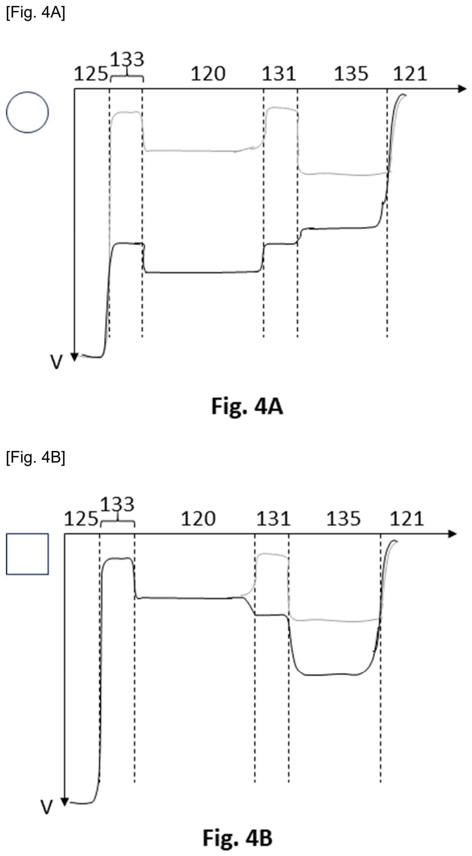

Les figures 4A à 4D sont des représentations schématiques illustrant l'évolution du potentiel électrique au passage de diverses régions du pixel de profondeur 5, correspondant aux états de polarisations repérés sur la figure 2B. La forme géométrique élémentaire permettant de repérer l'état de polarisation correspondant du chronogramme est dessiné en haut à gauche de chacune des figures 4A à 4D. Sur ces figures, l'axe des ordonnées donne la valeur du potentiel électrique à une position du pixel de profondeur 5 repérée sur l'axe des abscisses. Les différentes régions du pixel de profondeur 5 sont repérées par des lignes verticales en pointillés et une référence placée en vis-à-vis sur l'axe des abscisses. On passe successivement de la zone de collecte 125, au canal de collecte 133, à la région photosensible 120, à la barrière 131, à la région mémoire 135 et enfin à la zone de pincement 121.

Sur chacune des figures 4A à 4D, on a représenté schématiquement par une ligne grise-claire, l'évolution du potentiel électrique à l'intérieur du pixel de profondeur 5 lorsque les potentiels électriques TGZ, TGMEM, TGRST, VLO2, VLO3, sont égaux à -0,8 V ; EXP à -2,0 V ; VLO1 à -0,5 V ; et VRT à 1,8 V. Une ligne noire représente schématiquement l'évolution du potentiel pour l'état de polarisation correspondant.

Lorsqu'une scène est éclairée par une source de lumière périodique en amplitude de période P_{S}, le chronogramme conduit à une intégration d'une partie du signal lumineux réfléchi par la scène, sur des intervalles de temps périodiques de période égale à la période P_{S} et de durée égale à P_{S}/4.

Le chronogramme est adapté à un capteur d'une image comprenant plusieurs pixels de profondeur 5 agencés en matrice. Il comporte successivement une phase d'initialisation T0, une phase d'échantillonnage T1 et une phase de lecture de la matrice TM. La phase de lecture de la matrice TM consiste en une première phase d'attente T2, en une première phase de lecture T3, une phase d'évacuation de charges T4, une deuxième phase de lecture T5 et une deuxième phase d'attente T6. Le cumul des phases consécutives T0, T1 et TM constitue une phase d'acquisition d'une image en profondeur, ou d'acquisition d'une trame, par exemple si le capteur est apte à capturer plusieurs images successives. Le cas échéant, la phase de lecture de la matrice TM d'une trame peut être immédiatement suivie de la phase d'initialisation T0 de la trame suivante.

Afin de déterminer une information de profondeur à partir du signal lumineux périodique reçu par le capteur au cours d'une phase d'acquisition d'une image, le pixel de profondeur 5 peut appartenir à un macro-pixel Z comprenant plusieurs pixels de profondeur 5 identiques. Le cas échéant, les phases d'échantillonnage T1 de pixels de profondeur 5 distincts du macro-pixel Z sont décalées d'une fraction de période P_{S}, modulo la période P_{S}. Un macro-pixel Z peut par exemple consister en 4 pixels de profondeur 5 ayant leurs phases d'échantillonnage T1 décalées deux-à-deux d'un quart de la période P_{S}, modulo la période P_{S}.

Alternativement, une information de profondeur peut être déterminée à partir du signal lumineux périodique reçu par le capteur au cours de phase d'acquisition de trames successives. A titre d'exemple, les phases d'échantillonnage T1 de trames successives peuvent être décalées d'un quart de la période P_{S} modulo la période P_{S}, ou le signal lumineux est décalé d'un quart de la période P_{S} modulo la période P_{S} d'une trame à la suivante. L'information de profondeur est ensuite déterminée à partir des échantillons collectés par le pixel de profondeur 5 au cours des phases d'acquisition des trames successives. D'autres arrangements sont possibles encore, permettant d'acquérir une information de profondeur à partir d'échantillons collectés sur plusieurs trames avec un macro-pixel Z d'au moins un pixel de profondeur 5.

Au cours de la phase d'acquisition d'une image ou d'une trame, les potentiels électriques VLO1, VLO2, VLO3 et VRT sont fixes. A titre d'exemple, VLO1 est égal à -0,5 V ou 0 V. VLO2 est par exemple égal à -0,8 V. VLO3 est par exemple égal à -0,8 V. VRT est par exemple égal à 1,8 V.

Au cours des phases d'initialisation et d'échantillonnage T0, T1 et des première et deuxième phases d'attente T2, T6, les premier et deuxième interrupteurs 56, 57 sont à un état passant. VL03 est strictement inférieur à VL01 de sorte que, lorsque le premier interrupteur 56 est passant, des trous issus de la zone de pincement 121 sont attirés le long de la grille de pincement 114 par un champ électrique entre la zone de pincement 121 et la grille de pincement 114. Ainsi, ces trous forment avec la région mémoire 135 une jonction latérale passivant la région mémoire 135.

Au cours de la phase d'initialisation T0, la région photosensible 120 et la région mémoire 135 sont vidées d'éventuelles charges électriques qu'elles pourraient contenir. Pour cela, les potentiels électriques TGRST, TGMEM, TGZ sont tout d'abord, tous trois, égaux à une valeur haute V_{H}. Le pixel de profondeur 5 est dans un état de polarisation correspondant à la figure 4A, pour lequel le potentiel électrique de la région photosensible 120 est strictement supérieur au potentiel électrique de la barrière 131, qui est à son tour strictement supérieur au potentiel électrique de la région mémoire 135. Des électrons contenus dans la région mémoire 135 s'écoulent ainsi, sous l'action d'un champ électrique entre la région mémoire 135 et la région photosensible 120, depuis la région mémoire 135 vers la région photosensible 120.

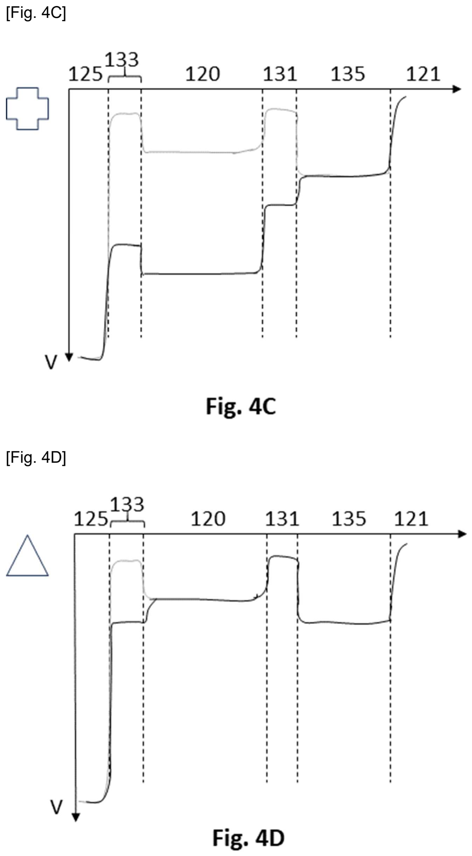

TGMEM est ensuite basculé à une valeur basse V_{L}, TGRST et TGZ étant par ailleurs maintenus à la valeur haut V_{H}. La valeur V_{L} est dans cet exemple égale à -0,8 V. La valeur V_{H} est égale à 1,8 V. L'état de polarisation correspondant est représenté en figure 4C. Pour celui-ci, le potentiel électrique de la barrière 131 est strictement inférieur à celui de la région photosensible 120, empêchant ainsi les électrons de se déplacer depuis la région photosensible 120 vers la région mémoire 135. Dans cet état, le potentiel électrique du canal de collecte 133 est préférentiellement strictement supérieur au potentiel électrique de la barrière 131, ainsi des charges électriques ne pouvant être contenues dans la région photosensible 120 lorsqu'elle est en limite de capacité, s'écoulent vers la zone de collecte 125 plutôt que dans la région mémoire 135.

Enfin, TGZ est basculé à la valeur V_{L}, TGMEM et TGRST étant par ailleurs maintenus à respectivement V_{L} et V_{H}. Cet état de polarisation correspond à la situation de la figure 4D pour laquelle aucune barrière de potentiel n'est présente entre la région photosensible 120 et la zone de collecte 125. Pour celui-ci, le potentiel électrique augmente au passage de la région photosensible 120 à la zone de collecte 125, en passant le canal de collecte 133. Ainsi, un champ électrique interne au pixel de profondeur 5 entraîne des électrons présents dans la région photosensible 120, notamment ceux en provenance de la région mémoire 135, depuis la région photosensible 120 vers la zone de collecte 125. A l'issue de la phase d'initialisation T0, la région mémoire 135 et la région photosensible 120 sont sensiblement dépourvues de charges électriques libres ; elles sont dites initialisées. Elles sont à des potentiels électriques respectifs, dits de pincement.

Au cours de la phase d'échantillonnage T1, on applique un train d'impulsions périodique à la grille de transfert 111. TGMEM est une fonction créneau périodique de période P_{S}, entre V_{H} et V_{L}. Ici, à chaque période de la fonction créneau, TGMEM est égal à V_{H} pendant une durée égale à P_{S}/4. Pendant cette phase, TGRST bascule entre V_{H} et V_{L}, en opposition de phase par rapport à TGMEM. On bascule ainsi d'un état de polarisation illustré sur la figure 4B, pour lequel des charges électriques transitent depuis la région photosensible 120 vers la région mémoire 135 au cours des impulsions, à un état de polarisation illustré sur la figure 4D commenté ci-dessus, pour lequel des charges électriques transitent depuis la région photosensible 120 vers la zone de collecte 125. A l'issue de la phase d'échantillonnage T1, la région mémoire 135 contient une quantité de charges électriques photo-générées correspondant à un échantillon.

Tout au long de la phase d'échantillonnage T1, le signal lumineux est actif (référence SL sur le chronogramme). De préférence, le signal lumineux SL n'est actif qu'au moment de la phase d'échantillonnage T1. Des moyens, comme une horloge ou un signal de synchronisation, permettent de synchroniser le signal lumineux avec le circuit de lecture. Ces moyens peuvent être externes ou intégrés au capteur, en totalité ou en partie.

En figure 4B, le potentiel électrique croit en passant de la région photosensible 120 à la région mémoire 135, de sorte qu'un champ électrique interne génère un déplacement des électrons de la région photosensible 120 jusqu'à la région mémoire 135. Les électrons sont des électrons photo-générés par le signal lumineux, c'est-à-dire que ce sont des électrons se trouvant dans la bande de conduction de la région photosensible 120 suite à l'absorption d'un ou plusieurs photons du signal lumineux.

La première phase d'attente T2 est une phase d'attente de sélection de la ligne ou de la colonne de la matrice à laquelle le pixel de profondeur 5 appartient. Cette phase est généralement mise à profit pour lire d'autres lignes ou colonnes. Au cours de cette phase, TGZ et TGMEM sont égaux à V_{L}, tandis que TGRST est égal à V_{H}. Cette situation est illustrée en figure 4D et commentée ci-dessus. Elle permet d'éviter que d'éventuelles charges électriques additionnelles générées dans la région photosensible 120 après la phase d'échantillonnage T1, ne soient transférées à la région mémoire 135 entre la phase d'échantillonnage T1 et la lecture de la valeur de l'échantillon collecté dans la région mémoire 135 au cours de la phase d'échantillonnage T1. Les charges électriques additionnelles sont évacuées vers la zone de collecte 125. Cette fonction est parfois appelée anti-éblouissement (ou « anti-blooming, en anglais).

La première phase d'attente T2 est suivie d'une première phase de lecture T3. La première phase de lecture T3 commence lorsque le transistor de sélection 54 est mis à un état passant (RD à une valeur basse). Les premier et deuxième interrupteurs 56, 57 sont ensuite ouverts (EXP à une valeur haute). Au moment de l'ouverture des premier et deuxième interrupteurs 56, 57, le potentiel électrique TGMEM de la grille de transfert 111 est à la valeur basse V_{L}, strictement inférieure au potentiel électrique VLO1 de la zone de pincement 121. Ainsi, des trous issus de la zone de pincement 121 sont attirés le long de la grille de transfert 111 par un champ électrique entre la zone de pincement 121 et la grille de transfert 111, et forment ainsi une région d'inversion en contact avec la grille de transfert 111. La région d'inversion forme avec la région mémoire 135 une jonction latérale passivant la région mémoire 135 le long de la grille de transfert 111.

Avantageusement, VLO3 est inférieur ou égal à VLO1, ainsi des trous issus de la zone de pincement 121 passivent la région mémoire 135 le long de la grille de pincement 114 au cours des phases d'initialisation T0, d'échantillonnage T1 et de lecture de la matrice TM, selon un effet technique similaire à celui mis en œuvre pour la formation de la région d'inversion.

La zone de stockage commandable comporte une capacité de couplage C_{RD} qui a une première borne formée par la région mémoire 135 et une deuxième borne formée par l'électrode 102 de la grille de transfert 111. En fonctionnement, la capacité de couplage C_{RD} résulte de deux capacités dans un agencement en série ; une première capacité consistant en l'électrode 102, une partie du revêtement diélectrique 129 en vis-à-vis de la région mémoire 135 et la région d'inversion ; une deuxième capacité consistant en la région d'inversion, la région mémoire 135 et la jonction séparant la région d'inversion de la région mémoire 135. A partir de cette étape de la première phase de lecture T3, la zone de pincement 121 et l'électrode 102 de la grille de transfert 111 sont déconnectées du premier circuit de lecture, c'est-à-dire qu'elles ne sont reliées au circuit de lecture par aucune liaison électrique permettant de conduire un courant électrique significatif. Le potentiel électrique de la région d'inversion est par conséquent laissé flottant. L'électrode 102 de la grille de transfert 111 constitue une borne flottante de la capacité de couplage C_{RD} de sorte que son potentiel électrique varie sous l'influence du potentiel électrique de la région mémoire 135, ou, dit en d'autres termes, la différence de potentiel aux bornes de la capacité de couplage C_{RD} reste constante tant que les premier et deuxième interrupteurs 56, 57 sont maintenus ouverts.

Aucun courant électrique ne circulant à l'intérieur du pixel de profondeur 5 lors de la première phase de lecture T3, le potentiel électrique de la deuxième borne de C_{RD} reste égal à un potentiel électrique Vinit constant après ouverture des premier et deuxième interrupteurs 56, 57. Vinit est égal à V_{L} additionné d'un potentiel électrique V_{kTC} correspondant à un bruit thermique du premier circuit de lecture. La valeur du potentiel électrique Vinit est lue sur la ligne de sortie et stockée en pied de colonne.

Une phase d'évacuation de charges T4 fait suite à la première phase de lecture T3. La phase d'évacuation de charges T4 commence lorsque TGZ bascule à la valeur haute V_{H}, TGMEM et TGRST étant respectivement maintenus à V_{L} et V_{H}. Au cours de cette phase, le pixel de profondeur 5 est dans l'état de polarisation de la figure 4C. Le potentiel électrique de la région photosensible 120 est strictement supérieur au potentiel électrique de la barrière 131, qui est à son tour strictement supérieur au potentiel électrique de la région mémoire 135. Les charges électriques contenues dans la région mémoire 135 s'écoulent ainsi, sous l'action d'un champ électrique entre la région mémoire 135 et la région photosensible 120, depuis la région mémoire 135 vers la région photosensible 120.

A l'issue de la phase d'évacuation de charges T4, la région mémoire 135 est vidée des charges électriques qui avaient été transférées depuis la région photosensible 120 au cours de la phase d'échantillonnage T1. Elle retourne à son potentiel de pincement. Les potentiels électriques respectifs de la région mémoire 135 et de deuxième borne de la capacité de couplage C_{RD} varient de la même quantité au cours de la phase T4.

La phase d'évacuation de charges T4 est suivie d'une deuxième phase de lecture T5. Le transistor de sélection 54 est maintenu à un état passant au cours de la première phase de lecture T3, de la phase d'évacuation de charges T4 et de la deuxième phase de lecture T5. La deuxième phase de lecture T5 se termine lorsque le transistor de sélection 54 est basculé à un état bloquant (RD à une valeur haute).

La deuxième phase de lecture T5 commence lorsque TGZ bascule à la valeur basse V_{L}, TGMEM et TGRST étant respectivement maintenus à V_{L} et V_{H}. Cet état de polarisation correspond à celui de la figure 4D pour lequel les charges électriques migrent de la région photosensible 120 vers la zone de collecte 125. Le potentiel électrique Vsig de la deuxième borne est lu sur la ligne de sortie et stocké en pied de colonne. Vsig est représentatif du nombre de charges électriques photo-générées et collectées dans la région mémoire 135 au cours de la phase d'échantillonnage T1.

Les premier et deuxième interrupteurs 56, 57 étant maintenus ouverts après la première phase de lecture T3, jusqu'à la deuxième phase de lecture T5, les différences de potentiel électrique respectives aux bornes des première et deuxième capacités restent constantes, ainsi la région d'inversion est maintenue de sorte que des trous de la région d'inversion ne se recombinent pas à des charges photo-générées de la région mémoire 135 et de sorte que la valeur de la capacité de couplage C_{RD} reste sensiblement constante.

Dans cet exemple, le capteur comporte des moyens pour opérer un double échantillonnage corrélé. Les moyens comprennent notamment la première phase de lecture T3, le stockage de Vinit lu en pied de colonne et une cellule analogique produisant un signal proportionnel à la différence de Vsig et Vinit. La cellule analogique soustrait par exemple Vinit à Vsig. Les lectures de Vinit et Vsig étant consécutives, sans modification de l'état des premier et deuxième interrupteurs 56, 57 entre les première et deuxième phases de lecture T3, T5, la lecture de Vsig ne souffre d'aucun bruit thermique additionnel à celui déjà présent lors de la lecture de Vinit. Ainsi, la soustraction de Vinit à Vsig permet de supprimer le bruit kTC. Les lectures de Vsig et Vinit sont dites corrélées.

Les potentiels électriques lus sur le noeud de lecture sont égaux au potentiel électrique de la région mémoire 135 multipliés par un facteur de conversion égal au rapport C_{RD}/(C_{RD} + C_{SN}), où C_{SN} est la capacité du noeud de lecture. La capacité C_{SN} est induite par différents facteurs liés au design et aux matériaux, comme par exemple des lignes d'interconnexions, une ou des grilles de transistor... Il est préférable que le facteur de conversion soit le plus proche possible de 1. Il importe par conséquent d'augmenter C_{RD} par rapport à C_{SN}. Il est par exemple possible d'augmenter une dimension de la grille de transfert 111 autre que sa largeur ou de diminuer l'épaisseur du revêtement diélectrique 129 en regard de la région mémoire 135. La forme en U de la grille de transfert 111 est à cet égard avantageuse.

La deuxième phase de lecture T5 est suivie d'une deuxième phase d'attente T6 optionnelle au cours de laquelle d'autres lignes de la matrice de pixel sont éventuellement sélectionnées. Les potentiels électriques du chronogramme sont à des valeurs identiques à celles de la première phase d'attente T2. Après la deuxième phase d'attente T6, par exemple immédiatement après, les phases d'initialisation T0, d'échantillonnage T1 et de lecture de la matrice TM peuvent être répétées pour acquérir une autre trame.

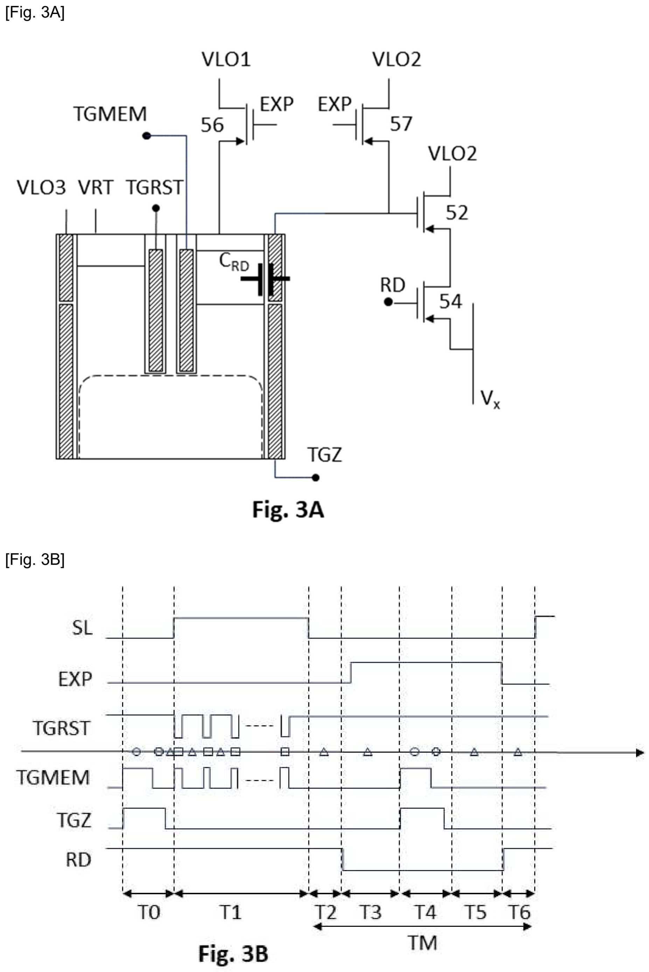

A présent, en lien avec la figure 3A, il va être décrit un deuxième circuit de lecture du capteur adapté à l'exemple de pixel de profondeur 5 des figures 1A et 1B. Sur la figure 3A, on a adopté une représentation schématique similaire à la figure 2A. Un chronogramme illustrant un fonctionnement possible du deuxième circuit de lecture est représenté en figure 3B. Seules les différences avec le premier circuit et le chronogramme de la figure 2B sont explicitement décrites ci-dessous.

A titre d'exemple, les premier et deuxième interrupteurs 56, 57 sont ici de simples transistors PMOS. La source du transistor 56 est connectée électriquement à la zone de pincement 121 via le septième contact 167. Le drain du transistor 56 est connecté électriquement au nœud ou au rail de fourniture du potentiel électrique VLO1. La grille du transistor 56 est connectée électriquement à un nœud ou un rail de fourniture du potentiel électrique EXP.

Le nœud de lecture est connecté électriquement à la grille de pincement 114 en vis-à-vis de la région mémoire 135, via le quatrième contact 164. La source du transistor 57 est connectée électriquement au nœud de lecture. Le drain du transistor 57 est connecté électriquement au nœud ou au rail de fourniture du potentiel électrique VLO2. La grille du transistor 57 est connectée électriquement au nœud ou au rail de fourniture du potentiel électrique EXP.

La grille du transistor de précharge 52 est connectée électriquement à la grille de pincement 114 en vis-à-vis de la région mémoire 135 via le nœud de lecture. La grille de transfert 111 est connectée électriquement au nœud ou au rail de fourniture du potentiel électrique TGMEM.

Dans le mode de réalisation des figures 3A et 3B, VLO2 est inférieur ou égal à VLO1. Ainsi, au cours des phases d'initialisation T0, d'échantillonnage T1 et d'attente T2, des trous issus de la zone de pincement 121 sont attirés le long de la grille de pincement 114 par un champ électrique entre la zone de pincement 121 et la grille de pincement 114, et forment ainsi une région d'inversion en contact avec la grille de pincement 114. Au moment de l'ouverture des premier et deuxième interrupteurs 56, 57 (canaux respectifs des transistors bloqués) au cours de la première phase de lecture T3, la région d'inversion est maintenue le long de la grille de pincement 114. La région d'inversion forme avec la région mémoire 135 une jonction latérale passivant la région mémoire 135 le long de la grille de pincement 114.

La zone de stockage commandable comporte une capacité de couplage C_{RD} qui a une première borne formée par la région mémoire 135 et une deuxième borne formée par l'électrode 102 de la grille de pincement 114 en vis-à-vis de la région mémoire 135. En fonctionnement, la capacité de couplage C_{RD} résulte de deux capacités dans un agencement en série ; une première capacité consistant en l'électrode 102 de la grille de pincement 114, une partie du revêtement diélectrique 129 en vis-à-vis de la région mémoire 135 et la région d'inversion ; une deuxième capacité consistant en la région d'inversion, la région mémoire 135 et la jonction séparant la région d'inversion de la région mémoire 135.

Une fois les premier et deuxième interrupteurs 56, 57 ouverts, l'électrode 102 de la grille de pincement 114 constitue une borne flottante de la capacité de couplage C_{RD} de sorte que son potentiel électrique varie sous l'influence du potentiel électrique de la région mémoire 135, ou, dit en d'autres termes, la différence de potentiel aux bornes de la capacité de couplage C_{RD} reste constante tant que les premier et deuxième interrupteurs 56, 57 sont maintenus ouverts.

Avantageusement, V_{L} est inférieur ou égal à VLO1, ainsi des trous issus de la zone de pincement 121 passivent la région mémoire 135 le long de la grille de transfert 111 au cours de la phase de lecture de la matrice TM, selon un effet technique similaire à celui mis en œuvre pour la formation de la région d'inversion.

La séquence du chronogramme au cours de la phase d'évacuation de charges T4 peut être identique à la phase correspondante de la figure 2B. Ici, comme la grille de transfert 111 demeure commandable au cours de la phase de lecture de la matrice TM, la séquence du chronogramme au cours de la phase d'évacuation de charges T4 est similaire ou identique à celle de la phase d'initialisation T0. Ainsi, on passe par un état de polarisation du pixel de profondeur 5 pour lequel TGMEM et TGZ sont tous les deux égaux à V_{H} permettant de centrer le transfert des charges électriques depuis la région mémoire 135, entre la grille de transfert 111 et la grille de transfert inverse 112. Le transfert est ainsi plus efficace.

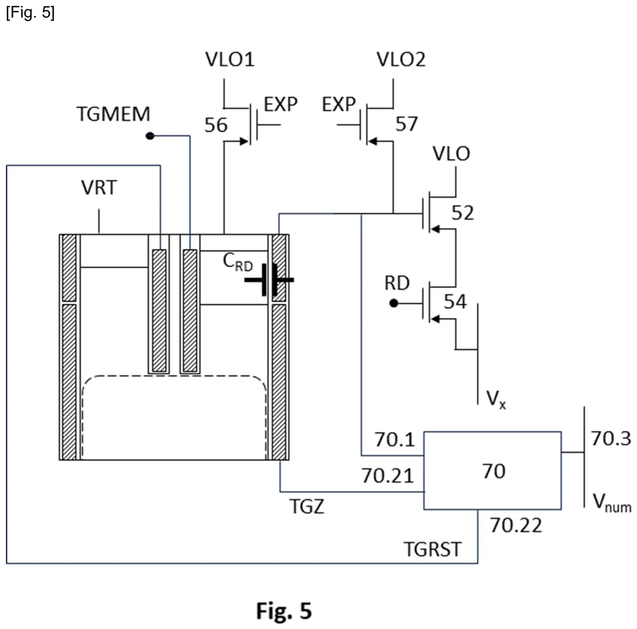

En figure 5, on a représenté une variante du deuxième circuit de lecture permettant d'augmenter une dynamique de détection des échantillons du capteur et/ou du pixel de profondeur 5. Elle tire profit du fait qu'il n'est pas nécessaire de déconnecter la grille de transfert 111 pour lire le potentiel électrique du nœud de lecture. Seules les différences avec le deuxième circuit de lecture sont explicitement décrites.

Dans cette variante, le deuxième circuit de lecture comporte en outre un module de contrôle 70. Le module de contrôle 70 comporte une entrée 70.1, une première et une deuxième sorties d'activation 70.21, 70.22 et une sortie numérique 70.3. La première sortie d'activation 70.21 est reliée électriquement à la grille de transfert inverse 112. La deuxième sortie d'activation 70.22 est reliée électriquement à la grille d'initialisation 113. L'entrée 70.1 est connectée électriquement au nœud de lecture.

Le module de contrôle 70 comporte un compteur. En fonctionnement, les premier et deuxième interrupteurs 56, 57 sont ouverts au cours de la phase d'échantillonnage T1, préférentiellement en début de la phase d'échantillonnage T1. Ils peuvent être maintenus ouverts jusqu'au terme de la deuxième phase de lecture T5, notamment pour effectuer un double échantillonnage corrélé permettant de réduire le bruit kTC. Alternativement, ils sont fermés à l'issue de la phase d'échantillonnage T1, par exemple en début ou au cours de la première phase d'attente T2. Le cas échéant, les séquences de polarisation de la première phase de lecture T3, de la phase d'évacuation de charges T4 et de la deuxième phase de lecture T5 sont identiques à celles représentées sur la figure 3B.

Au cours de la phase d'échantillonnage T1, le module de contrôle 70 opère un processus itératif. Une nouvelle itération du processus itératif commence à chaque fois que le potentiel électrique Vd du noeud de lecture en entrée du module de contrôle 70 franchit un seuil de potentiel électrique prédéterminé. Le seuil peut par exemple correspondre à une quantité maximale de charges électriques que peut contenir la région mémoire 135.

Dès que le franchissement de seuil est détecté par le module de contrôle 70, le compteur est incrémenté. Le module de contrôle 70 effectue ensuite une étape de vidange de la région mémoire 135. Au cours de celle-ci, la grille de transfert inverse 112 et la grille d'initialisation 113 sont polarisées via les première et deuxième sorties d'activation 70.21, 70.22 de façon à ce que TGZ et TGRST soient égaux à V_{H}. De préférence, TGZ et TGRST sont maintenus à V_{H} au cours d'un multiple entier supérieur ou égal à 1 de la période P_{S}. Il est également possible de maintenir TGZ et TGRST au cours d'une période de temps inférieure à la durée séparant deux créneaux consécutifs de la fonction créneau suivie par TGMEM, notamment si la période de temps est suffisamment longue pour vider entièrement la région mémoire 135.

Au cours de l'étape de vidange, TGMEM peut être égal à V_{L} ou V_{H}. TGMEM peut par exemple poursuivre sa fonction créneau. L'étape de vidange se termine en basculant TGZ de V_{H} à V_{L}, tout en maintenant TGRST et TGMEM à respectivement V_{H} et V_{L}. La région photosensible 120 est par conséquent vidée de ses charges électriques libres. TGRST reprend ensuite sa fonction créneau en opposition de phase de TGMEM jusqu'à une nouvelle itération ou la fin de la phase d'échantillonnage T1.

Le processus itératif se poursuit tout au long de la phase d'échantillonnage T1. Suite à la phase d'échantillonnage T1, on effectue la phase de lecture de la matrice TM de la figure 3B. Vsig est alors représentatif du nombre de charges électriques photo-générées et collectées dans la région mémoire 135 au cours de la dernière itération avortée du processus itératif. Un potentiel électrique Vnum correspondant à l'incrément final du compteur à l'issue de la phase d'échantillonnage T1 est lu sur la sortie numérique 70.3 par le circuit de lecture. Vnum est un signal d'au moins un bit. Il peut être un bus de plusieurs bits.

La cellule analogique peut par exemple comprendre un convertisseur numérique-analogique convertissant Vnum en une valeur analogique Vi correspondant aux charges électriques qui ont été stockées dans la région mémoire 135 au-cours des itérations complètes du processus itératif. La cellule analogique produit un signal proportionnel à la soustraction de Vinit à (Vsig + Vi), correspondant à la valeur de l'échantillon. La cellule analogique produit par exemple un signal représentatif du nombre de remplissages de la région mémoire, entrant dans le calcul de l'échantillon.

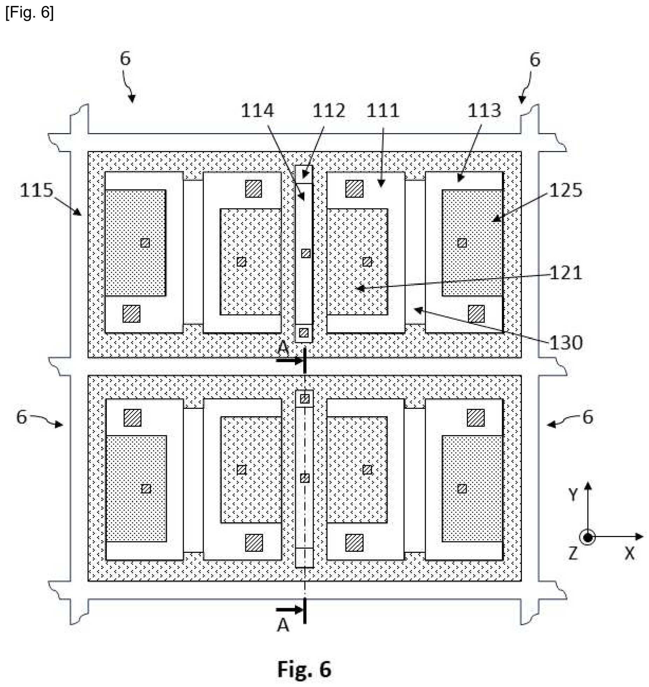

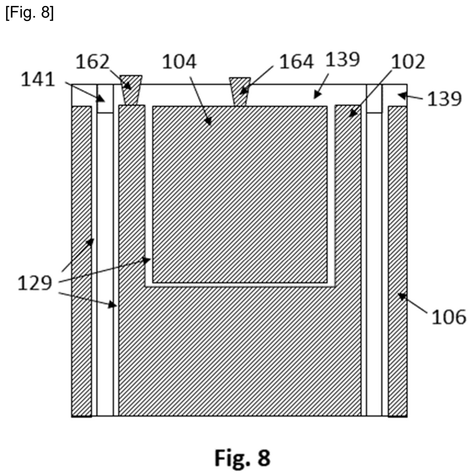

A présent, un capteur comportant une matrice de pixels de profondeur 6 va être décrit en lien avec la figure 6. Tous les pixels de profondeur 6 sont identiques. Chaque pixel de profondeur 6 est une variante du pixel de profondeur 5 illustré en figures 1A et 1B. Seules les différences de la variante avec le pixel de profondeur 5 sont explicitement décrites. La figure 8 est une vue schématique selon la coupe A-A de la figure 6.

La grille de transfert inverse 112 est plane. Elle s'étend selon un plan vertical parallèle au plan (Y, Z). Le pixel de profondeur 6 est dépourvu de grille de pincement 114 additionnelle. La grille de pincement 114 s'étend dans le même plan vertical que la grille de transfert inverse 112. Elle occupe l'encoche pratiquée dans la grille de transfert inverse 112.

Chaque grille de transfert inverse 112 et chaque grille de pincement 114 sont communes à deux pixels de profondeur 6 contigus de la matrice. Ces derniers sont par exemple symétriques l'un de l'autre par rapport au plan vertical selon lequel la grille de transfert inverse 112 et la grille de pincement 114 s'étendent, comme cela est représenté ici.

Chaque pixel de profondeur 6 comporte une tranchée d'isolation périphérique 115. La tranchée d'isolation périphérique 115 s'étend verticalement dans une région périphérique du pixel en vis-à-vis de la voie d'écoulement additionnelle et de la région photosensible 120. Elle a, dans cet exemple, une forme en U en vue de dessus entourant la voie d'écoulement additionnelle, la région photosensible 120, la grille d'initialisation 113 et la grille de transfert 111. Elle entoure la zone de pincement 121. Elle s'étend ici depuis la face supérieure 100.1, de préférence sur une profondeur sensiblement égale à l'épaisseur du substrat 100.

Dans cet exemple, la tranchée d'isolation périphérique 115 s'étend le long de 3 faces consécutives du pixel de profondeur 6 de façon à les recouvrir entièrement. Ainsi, les tranchées d'isolation périphérique 115 de la matrice forment un maillage continu tel que chaque maille entoure deux pixels de profondeur 6 contigus de la matrice.

La tranchée d'isolation périphérique 115 comporte une électrode verticale 106 revêtue d'un revêtement diélectrique 129. Les électrodes verticales 106 forment un maillage continu et d'un seul tenant. Le revêtement diélectrique 129 de la tranchée d'isolation périphérique 115 isole électriquement l'électrode verticale 106 du substrat 100. Ici, la tranchée d'isolation périphérique 115 comporte en outre une région isolante 139 recouvrant l'électrode verticale 106 et affleurant la face supérieure 100.1 du substrat 100. L'électrode verticale 106 est par exemple en silicium polycristallin dopé. Le revêtement diélectrique 129 est par exemple en oxyde de silicium. La région isolante 139 est par exemple en oxyde de silicium. Le maillage d'électrodes verticales 106 est connecté, par exemple en périphérie de la matrice, à un potentiel électrique fixe permettant de passiver des régions des pixels de profondeur 6 en regard des tranchées d'isolation périphérique 115.

Les zones dopées périphériques 141 de deux pixels de profondeur 6 dans une maille se rejoignent au niveau du plan de la grille de transfert inverse 112, pour former une zone d'un seul tenant.

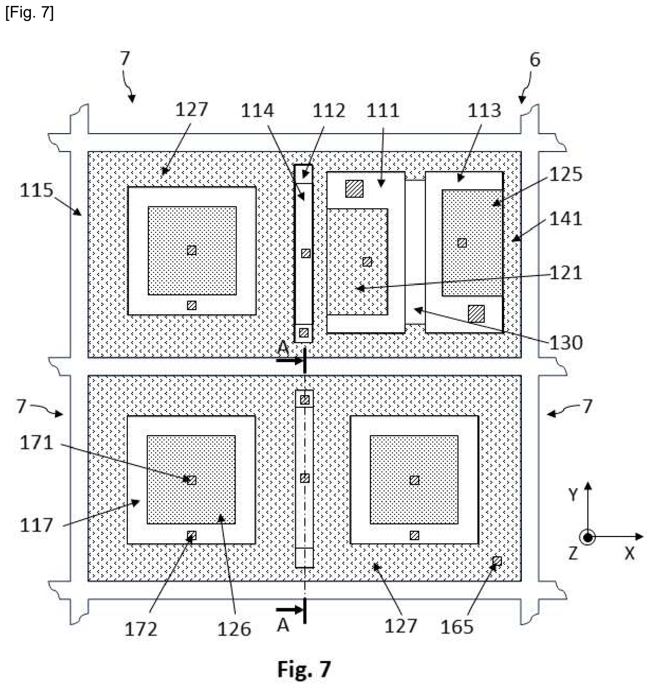

A présent, il va être décrit un capteur comportant une matrice de pixels mixant des pixels d'intensité 7 et des pixels de profondeur 6. Plusieurs pixels d'intensité 7 peuvent être insérés dans la matrice de pixels. Sur la figure 7, on a représenté un ensemble de 4 pixels de la matrice en vue de dessus. La figure 8 est une vue selon la coupe A-A de la figure 7. L'ensemble de 4 pixels est par exemple répété périodiquement pour former la matrice. Il comporte ici 3 pixels d'intensité 7 et un pixel de profondeur 6. Seules les différences avec le capteur de la figure 6 sont explicitement décrites. Les pixels de profondeur et d'intensité 6, 7 ont des empreintes horizontales superposables, c'est-à-dire que toutes leurs dimensions horizontales sont égales.

Le pixel de profondeur 6 est identique à celui décrit en lien avec la figure 6. Chaque pixel d'intensité 7 peut être tout type de pixel délivrant un signal proportionnel à l'intensité d'une partie du rayonnement électromagnétique issu de la scène et incident sur la face inférieure du substrat 100, ne comprenant pas le signal lumineux. Le pixel d'intensité 7 peut par exemple être un pixel similaire ou identique à celui décrit dans le document US 2019/0237499 A1.

Chaque pixel d'intensité 7 comporte une grille de transfert 117, une zone de détection 126 et un caisson 127. Il comporte en outre une tranchée d'isolation périphérique 115 identique au pixel de profondeur 6. La matrice de pixels de la figure 7 est obtenue en remplaçant des pixels de profondeur 6 de la matrice de la figure 6 par des pixels d'intensité 7. Ainsi, les tranchées d'isolation périphérique 115 forment un maillage identique à celui de la figure 6.

La zone de détection 126 et le caisson 127 sont dopés de types de conductivité opposés. Dans cet exemple, sans que cela soit essentiel, le caisson 127 est dopé du même type de conductivité que la zone de pincement 121 et sa zone dopée périphérique 141. Le caisson 127 et la zone de pincement 121 peuvent par exemple résulter d'une ou plusieurs étapes d'implantation communes.

Une première maille du maillage formée par les tranchées d'isolation périphérique 115 entourent deux pixels d'intensité 7. Une deuxième maille entoure un pixel de profondeur 6 avec un pixel d'intensité 7. Dans la première maille, les caissons 127 se rejoignent pour former une zone dopée d'un seul tenant. Similairement, la zone de pincement 121 et sa zone dopée périphérique 141 rejoignent le caisson 127 pour former une autre zone dopée d'un seul tenant.

La grille de transfert 117 s'étend verticalement dans le substrat 100 depuis la face supérieure 100.1. Elle a une forme sensiblement carrée ou rectangulaire en vue de dessus. Elle entoure de toute part la zone de détection 126. La zone de détection 126 s'étend d'un bord à l'autre de la grille de transfert 117. Le caisson 127 s'étend d'un bord à l'autre d'une tranchée d'isolation périphérique 115. Il entoure la grille de transfert 117.

Des charges électriques photo-générées dans une région photosensible du pixel d'intensité 7 sont collectées dans la zone de détection 126 lorsque la grille de transfert 117 est activée. La grille de transfert 117 est située à l'aplomb de cette région photosensible.

Le pixel de profondeur 6 ne partage pas sa grille de transfert inverse 112 et sa grille de pincement 114 avec un pixel de profondeur 6 voisin. Avantageusement, chaque pixel d'intensité 7 est séparé d'un pixel voisin par une grille de transfert inverse 112 et une grille de pincement 114 identiques à celles du pixel de profondeur 6, et agencées de la même façon. Ainsi, tous les pixels d'intensité 7 présentent des caractéristiques de fonctionnement identiques. Les grilles de transfert inverse et de pincement 112, 114 de la première maille sont avantageusement polarisées par des contacts électriques, lorsque le capteur est en fonctionnement.

Pour chaque pixel d'intensité 7, la zone de détection 126 et la grille de transfert 117 sont connectés à un circuit de contrôle par, respectivement, un contact de lecture 171 et un contact de grille 172. Le circuit de contrôle peut être une partie du circuit de lecture ou un circuit indépendant. Les caissons 127 des pixels d'intensité 7 de la première maille sont connectés au circuit de contrôle par un cinquième contact 165. En fonctionnement, le caisson 127 du pixel d'intensité 7 de la deuxième maille est ici polarisé via le septième contact 167 et la zone de pincement 121.

A titre d'exemple, le capteur peut être configuré pour capturer une image couleur. Les pixels d'intensité 7 de l'ensemble de 4 pixels peuvent alors chacun être sensible dans une gamme de longueurs d'onde du spectre visible distincte des deux autres pixels d'intensité 7 de l'ensemble. Il est possible de les associer à un filtre pixellisé disposé en regard de la face inférieur du substrat 100 de sorte que chaque pixel soit exclusivement sensible à l'une des trois couleurs parmi le rouge, le vert ou le bleu.

Des modes de réalisation particuliers viennent d'être décrits. Différentes variantes et modifications apparaîtront à l'homme du métier. L'agencement particulier des grilles de transfert et de transfert inverse, entre-elles et par rapport à la voie d'écoulement, est notamment un élément essentiel au transfert bidirectionnel entre la région photosensible et la région mémoire permettant d'atteindre l'objectif de compacité de l'invention. Celui-ci est exploitable dans des pixels de profondeur similaires, connectés à d'autres types de circuits de lecture.

## Revendications

1. Capteur d'une image comprenant un circuit de lecture et une pluralité de pixels formés dans et/ou sur un substrat (100) semiconducteur du capteur, tel qu'au moins un parmi les pixels est un pixel de profondeur (5, 6), chaque pixel de profondeur comportant :
• une région photosensible (120) du substrat (100),
• une zone de stockage commandable comprenant :
▪ une voie d'écoulement de charges électriques s'étendant verticalement dans le substrat (100) à l'aplomb de la région photosensible (120) et comportant, dans des plans successifs depuis la région photosensible (120), une barrière de potentiel nommée barrière (131), un puits de potentiel nommé région mémoire (135), et une zone de pincement (121),
▪ une grille de transfert (111) s'étendant verticalement dans le substrat (100) à l'aplomb de la région photosensible (120), en vis-à-vis de la barrière (131),
▪ une grille de transfert inverse (112) s'étendant verticalement dans le substrat (100) en vis-à-vis de la barrière (131) et d'une partie supérieure de la région photosensible (120),
▪ une grille de pincement (114) s'étendant verticalement dans le substrat (100) en vis-à-vis de la région mémoire (135),
▪ une capacité de couplage (C_{RD}) comprenant une première borne formée par la région mémoire (135) et une deuxième borne formée par une partie conductrice (102) de la grille de transfert (111) ou de la grille de pincement (114) ;
• une voie additionnelle d'écoulement de charges électriques s'étendant verticalement dans le substrat (100) à l'aplomb de la région photosensible (120) comportant un puits de potentiel nommé zone de collecte (125) et une barrière de potentiel, nommée canal de collecte (133), intercalée entre la zone de collecte (125) et la région photosensible (120),
• une grille d'initialisation (113) s'étendant verticalement dans le substrat (100) à l'aplomb de la région photosensible (120), en vis-à-vis du canal de collecte (133),
le circuit de lecture étant configuré pour successivement :
• appliquer un train d'impulsions périodique à la grille de transfert (111) au cours d'une phase d'échantillonnage (T1) de sorte à écouler des charges électriques depuis la région photosensible (120) vers la région mémoire (135) au cours des impulsions,
• appliquer une différence de potentiel électrique entre la zone de pincement (121) et la grille de pincement (114), et une différence de potentiel électrique entre la zone de pincement (121) et la grille de transfert (111), de sorte à passiver la région mémoire (135) à partir de charges électriques issues de la zone de pincement (121),
• déconnecter, puis maintenir déconnectées, la zone de pincement (121) et la deuxième borne,
• activer la grille de transfert inverse (112) et la grille d'initialisation (113) de sorte à écouler des charges électriques depuis la région mémoire (135) vers la zone de collecte (125) au cours d'une phase d'évacuation de charges (T4),
• lire un potentiel électrique Vsig de la deuxième borne, tout en maintenant déconnectées la zone de pincement (121) et la deuxième borne.

2. Capteur selon la revendication 1, dans lequel le circuit de lecture est configuré pour lire un potentiel électrique Vinit de la deuxième borne antérieurement à la phase d'évacuation de charges (T4) et postérieurement à la déconnexion de la zone de pincement (121) et de la deuxième borne, le capteur étant tel qu'il comprend des moyens pour opérer un double échantillonnage corrélé à partir de Vinit et Vsig.

3. Capteur selon la revendication 2, dans lequel la deuxième borne de la capacité de couplage est formée par une partie conductrice (102) de la grille de pincement (114), et dans lequel le circuit de lecture comporte en outre un module de contrôle (70) connecté électriquement à la deuxième borne (102), à la grille de transfert inverse (112) et à la grille d'initialisation (113) et dans lequel le module de contrôle (70) est configuré pour successivement :
• incrémenter un compteur du module de contrôle (70),
• activer la grille de transfert inverse (112) et la grille d'initialisation (113) de sorte à écouler les charges électriques depuis la région mémoire (135) vers la zone de collecte (125),
à chaque fois qu'un potentiel électrique Vd de la deuxième borne franchit un seuil de potentiel prédéterminé au cours de la phase d'échantillonnage (T1) ;
le capteur étant tel que les moyens pour opérer le double échantillonnage corrélé prennent en compte un incrément du compteur à l'issue de la phase d'échantillonnage (T1).

4. Capteur selon l'une quelconque des revendications précédentes, dans lequel le circuit de lecture est en outre configuré pour activer la grille de transfert (111) au cours de la phase d'évacuation de charges (T4) après l'activation de la grille de transfert inverse (112).

5. Capteur selon l'une quelconque des revendications précédentes, dans lequel le circuit de lecture est configuré pour activer la grille d'initialisation (113) en opposition de phase de la grille de transfert (111) au cours de la phase d'échantillonnage (T1).

6. Capteur selon l'une quelconque des revendications précédentes, dans lequel, pour chaque pixel de profondeur, la grille de transfert (111) s'étend en regard de la région mémoire (135).

7. Capteur selon l'une quelconque des revendications précédentes, dans lequel, pour chaque pixel de profondeur (5, 6), la barrière (131), la région mémoire (135) et la zone de collecte (125) sont dopées d'un premier type de conductivité, et ont des concentrations en éléments dopants respectivement égales à N1, N2, N3 telles que N1 est strictement inférieur à N2, et N2 est strictement inférieur à N3.

8. Capteur selon la revendication 7, dans lequel, pour chaque pixel de profondeur (5, 6), la zone de pincement (121) est dopée d'un deuxième type de conductivité opposé au premier type de conductivité.

9. Capteur selon les revendications 7 ou 8, dans lequel le canal de collecte (133) a une concentration en éléments dopants égale à N1.

10. Capteur selon l'une quelconque des revendications 7 à 9, dans lequel, pour chaque pixel de profondeur (5, 6), la grille de transfert (111) a une forme en U en vue de dessus, entourant la voie d'écoulement de la zone de stockage commandable.

11. Capteur selon l'une quelconque des revendications précédentes, dans lequel la pluralité de pixels est agencée en matrice, dans lequel chaque pixel comporte une tranchée d'isolation périphérique (115) s'étendant verticalement dans une région périphérique du pixel en regard d'une région photosensible du pixel et dans lequel le circuit de lecture est configuré pour appliquer un potentiel électrique fixe commun à toutes les tranchées d'isolation périphérique (115).

12. Capteur selon la revendication 11, dans lequel chaque grille de pincement (114) et chaque grille de transfert inverse (112) sont agencées dans des plans de séparation de deux pixels contigus de la matrice de pixels.

13. Capteur selon la revendication 12, dans lequel les tranchées d'isolation périphérique (115) forment un maillage continu comportant des mailles telles que chaque maille entoure deux pixels, et dans lequel le circuit de lecture est connecté électriquement à une zone périphérique du maillage de sorte à appliquer le potentiel électrique fixe commun.

14. Capteur selon l'une quelconque des revendications 11 à 13, dans lequel les tous les pixels de la matrice ont la même taille, et dans lequel la matrice de pixels comporte des pixels d'intensité configurés pour délivrer un signal représentatif d'une intensité d'un flux lumineux incident.
